# EUROPÄISCHE PATENTSCHRIFT

(11) **EP 1 969 624 B1**
(45) Veröffentlichungstag und Bekanntmachung des Hinweises auf die Patenterteilung: **03.04.2019**
(21) Anmeldenummer: 07703582.2
(22) Anmeldetag: 02.01.2007
(51) Int. Cl.: H01L 23/367, H01L 23/373, H05K 1/02, H05K 3/46, H05K 3/42

(54) **INTEGRIERTES ELEKTRONISCHES BAUTEIL SOWIE KÜHLVORRICHTUNG FÜR EIN INTEGRIERTES ELEKTRONISCHES BAUTEIL**
INTEGRATED ELECTRONIC DEVICE AND COOLING DEVICE FOR AN INTEGRATED ELECTRONIC DEVICE
COMPOSANT ELECTRONIQUE INTEGRE ET DISPOSITIF DE REFROIDISSEMENT POUR COMPOSANT ELECTRONIQUE INTEGRE

(30) Priorität: 30.12.2005 DE 102005063281
(43) Veröffentlichungstag der Anmeldung: 17.09.2008
(73) Patentinhaber: ROBERT BOSCH GMBH, 70442 Stuttgart (DE)
(72) Erfinder: WIESA, Thomas, 71665 Vaihingen (DE); NUECHTER, Wolfgang, 71732 Tamm (DE); LISCHECK, Andre, 71665 Vaihingen (DE); LANGERJAHN, Ralf, 71409 Schwaikheim (DE)
(86) Internationale Anmeldenummer: PCT/EP2007/050006
(87) Internationale Veröffentlichungsnummer: WO 2007/077233

(56) Entgegenhaltungen:
- EP-A2- 1 049 362
- DE-A1- 4 218 112
- DE-A1- 4 222 838
- DE-A1- 10 127 268
- DE-A1- 19 506 664
- DE-A1- 19 528 632
- DE-A1- 19 723 409
- US-A1- 2003 184 969
- US-A1- 2005 077 362
- US-A1- 2005 145 414

## Beschreibung

### Stand der Technik

Die Erfindung geht aus von einem integrierten elektronischen Bauteil sowie einer Kühlvorrichtung für ein integriertes elektronisches Bauteil nach den Oberbegriffen der unabhängigen Ansprüche.

Integrierte elektronische Bauteile umfassen üblicherweise wenigstens eine Leiterplatte, auf der Leiterplatte angeordnete elektronische Leistungsbauelemente sowie ein Gehäuse, das die Leiterplatte wenigstens teilweise umgibt. Problematisch ist die Entwärmung der Leistungsbauelemente. Gerade durch kompaktere Bauformen sowie eine höhere Packungsdichte im Gehäuse wird die Entwärmung erschwert. Nach dem Stand der Technik werden die Leistungsbauelemente von integrierten elektronischen Bauteilen, insbesondere solcher für die zweidimensionale SMD-Montage ("surface mounted device"-Montage), durch die Leiterplatte ins Gehäuse meist metallisch entwärmt. Dabei wird der Wärmestrom durch die Leiterplatte mit so genannten thermischen Vias verbessert. Es handelt sich dabei um kleine Bohrungen oder Sacklöcher, die mittels Lasertechnik oder mechanisch mit einem Mikrobohrer erzeugt und zur Wärmeleitung genutzt werden. Zur Erhöhung der Wärmeleitfähigkeit werden die Vias verkupfert. Eine Unterseite der Leiterplatte wird dabei unmittelbar unterhalb des Leistungsbauelements an das Gehäuse angekoppelt, um die Wärme möglichst rasch an das Gehäuse abzuleiten. Für die Bewertung der Wärmeleitung wird der so genannte thermische Widerstand herangezogen, welcher bei gegebener Verlustleistung die Temperaturdifferenz zwischen Anfang und Ende des Wärmepfads angibt. Der thermische Widerstand wird in K/W gemessen und setzt sich additiv aus den thermischen Widerständen von Abschnitten des Pfads zusammen, den der Wärmestrom überwinden muss. Zur Minimierung des thermischen Übergangswiderstands von der Leiterplatte in das Gehäuse ist es bekannt, ein Wärmeleitmedium in Form einer Paste, eines Klebers oder einer Folie zwischen Leiterplatte und Gehäuse anzubringen. Nachteilig dabei ist, dass auf der Leiterplattenunterseite keine Bauteile platziert werden können. Außerdem bewirkt der oben beschriebene Aufbau, dass die Zwischenlagen durch die thermischen Vias unterbrochen werden. Dies bewirkt eine zusätzliche nachteilige Einschränkung des Layouts hinsichtlich Verdrahtung und Platzierung von Leistungsbauelementen.

### Würdigung

Die Offenlegungsschrift DE 19528632 A1 beschreibt eine Schaltungsanordnung mit einem Leistungsbauelement, wobei eine Entwärmung des Leistungsbauelements über ein die Schaltungsanordnung randseitig aufnehmendes Gehäuse vorgesehen ist. Hierzu ist das Leistungsbauelement auf einer in Form einer Standardplatine ausgebildeten Leiterplatte angeordnet. Kennzeichnend ist, dass die Leiterplatte ab dem Bereich des Leistungsbauelements randseitig mit ihrer Unterseite auf einem umlaufenden Rand des Gehäusebodens aufliegt. Zwischen dem Rand und dem darauf aufliegenden Teil der Leiterplatte ist eine wärmeleitende Schicht vorgesehen. Die Entwärmung des Leistungsbauelements erfolgt senkrecht durch die Leiterplatte auf die wärmeleitende Schicht und wird von dort direkt auf den Gehäuseboden weitergegeben. Die stärkste Wärmeableitung in das Gehäuse ist direkt unterhalb des Leistungsbauelements.

Die Offenlegungsschrift US 2005/0145414 A1 beschreibt eine elektronische Anordnung mit einer "metal plate, die unterhalb eines Leistungsbauelements angeordnet ist. Die Wärmeableitung erfolgt über Kontaktstellen der beschriebenen BVH auf die "metal plate" und nach einer Querleitung über weitere Kontaktstellen der BVH oberseitig der Leiterplatte in einem Bereich neben dem Leistungsbauelement. Es sind noch weitere Schichten im Aufbau beteiligt wie z.B. die "heat radiation layer" und "ground layer". Die Lehre ist auf eine Wärmeableitung im Form einer großflächigen Wärmeabstrahlung ("heat radiation") gerichtet und für eine erfolgreiche Entwärmung grundlegend.

In der Offenlegungsschrift US 2005/0077362 A1 wird ein elektronisches Bauelement als Zusammenbau von zwei Einzelbauteilen beschrieben. Durch den Zusammenbau ergibt sich eine Anordnung, durch die eine Innenlage aus einem wärmeleitfähigen Material zwischen zwei vor dem Zusammenbau vorgelegenen Leiterplatten gebildet ist.

### Vorteile der Erfindung

Bei einem erfindungsgemäßen integrierten elektronischen Bauteil weist eine Leiterplatte wenigstens eine Innenlage aus einem wärmeleitfähigen Material auf. Der große Vorteil dabei ist die günstige Entwärmung von Leistungsbauträgern zum Gehäuse, die auf der Leiterplatte platziert sind.

In einer bevorzugten Weiterbildung ist die Innenlage aus massivem Kupfer gebildet. Besonders bevorzugt weist die Leiterplatte zwei Innenlagen auf. Als günstige Dicke der Kupfer-Innenlagen werden Schichtdicken von beispielsweise 105µm, 210 µm oder 400 µm vorgeschlagen. Die Innenlage kann bevorzugt strukturiert (geätzt) werden.

Die Leistungsbauelemente können mit der Innenlage über wenigstens eine quer zur Leiterplatte angeordnete Kontaktöffnung thermisch gekoppelt sein, um die von den Leistungsbauelementen erzeugte Wärme in die Innenlage abzuführen. Als bevorzugte Kontaktöffnung kann eine Durchkontaktierung in Form einer Bohrung ausgebildet sein, die vertikal zur Leiterplatte ausgebildet ist. In einer besonders bevorzugten Ausgestaltung ist als Kontaktöffnung ein Sackloch (µ-Via bzw. Mikrovia) ausgebildet, das bevorzugt lasergebohrt ist. Ein µ-Via durch eine Standard-Leiterplatte hat beispielsweise einen thermischen Widerstand von ca. 200 K/W. Je nach Anforderung ist eine entsprechende Anzahl von µ-Vias parallel in der Leiterplatte angeordnet. Der große Vorteil dabei ist, dass auf der Leiterplattenunterseite ebenfalls Leistungsbauelemente platziert werden können. Es wird somit eine günstige Entkopplung zwischen einer Gehäusekonstruktion und Layout erreicht, und die zusätzlich nutzbare Leiterplattenfläche kann günstigerweise erhöht werden.

Zur thermischen Ableitung von der Innenlage ins Gehäuse ist bevorzugt ein Klemmrand ausgebildet, wobei die Wärme über eine Querleitung der Innenlage zum Klemmrand abgeführt wird. Günstigerweise müssen die Leistungsbauelemente bei dieser Konstruktion nicht mehr unmittelbar oberhalb einer Koppelfläche zwischen dem Gehäuse und der Leiterplatte angeordnet sein, was eine zusätzliche freie Gestaltung bei der Platzierung der Bauteile ermöglicht.

Weist die Leiterplatte im Bereich des Klemmrands wenigstens eine quer zur Leiterplatte angeordnete Kontaktöffnung auf, kann eine besonders günstige Wärmeableitung stattfinden. Bevorzugt ist zur elektrischen Isolation der Innenlage nach außen ein Material aus gefülltem organischem Substrat vorgesehen, das eine verbesserte Wärmeleitfähigkeit besitzt. Insbesondere kann ein so genanntes Prepreg vorgesehen sein. Es handelt sich dabei um eine Klebefolie, beispielsweise eine epoxidharz-imprägnierte und vorpolymerisierte Glashart-Klebefolie zum Aufbau von Multilayer-Leitplatten, die günstigerweise eine Wärmeleitfähigkeit von wenigstens 1W/mK aufweist. Bedingt durch das gute Fließverhalten werden alle Zwischenräume luftfrei ausgefüllt, und es entsteht dabei eine bevorzugte Lagenbindung und Haftfestigkeit von Prepeglagen und Innenlagen. Über diesen bevorzugten Schichtaufbau ist eine elektrische Isolation bei gleichzeitiger guter thermischer Leitfähigkeit gewährleistet.

Bei einer erfindungsgemäßen Kühlvorrichtung für ein integriertes elektronisches Bauteil weist die Leiterplatte zur Ableitung von Wärme aus den Leistungsbauelementen wenigstens eine Innenlage aus einem wärmeleitfähigem Material auf, wobei bevorzugt zwei Innenlagen aus massivem Kupfer ausgebildet sind. Es können jedoch als Innenlage auch andere wärmeleitfähige Materialien ausgebildet sein, beispielsweise Aluminiumkerne. Zur thermischen Kopplung der Leistungsbauelemente mit der Innenlage bzw. der Innenlage zum Gehäuse ist bevorzugt wenigstens eine quer zur Leiterplatte angeordnete Kontaktöffnung ausgebildet, beispielsweise in Form von Durchkontaktierungen in Form von Bohrungen oder in Form von Sacklöchern (µ-Vias). Letztere haben den Vorteil, dass auch auf der Leiterplattenunterseite Leistungsbauelemente platziert werden können. Zur Ableitung der Wärme aus der Innenlage zum Gehäuse ist bevorzugt ein Klemmrand ausgebildet.

Insgesamt wird mit dem erfindungsgemäßen Bauteil bzw. der erfindungsgemäßen Kühlvorrichtung im Rahmen von angepassten Gerätekonzeptionen eine kompaktere Aufbaumöglichkeit bereitgestellt, wobei jedoch eine vergleichbare zuverlässige bzw. sogar eine verbesserte Entwärmung stattfindet. Insbesondere ist mit den vorgeschlagenen Lösungen ein vorteilhafter Platzgewinn auf der Leiterplatte verbunden. Die erfindungsgemäßen Lösungen haben darüber hinaus den Vorteil, ein unabhängiges Kühlkonzept darzustellen, da der Klemmrand das Kühlkonzept definiert. Die vorgeschlagenen Lösungen können insbesondere bei allen Motorsteuergeräten in Leiterplattentechnik verwendet werden.

### Zeichnungen

Weitere Ausführungsformen, Aspekte und Vorteile der Erfindung ergeben sich auch unabhängig von ihrer Zusammenfassung in Ansprüchen, ohne Beschränkung der Allgemeinheit aus nachfolgend anhand von Zeichnungen dargestellten Ausführungsbeispielen der Erfindung.

Im Folgenden zeigen in einer schematischen Schnittdarstellung:
- Fig. 1: eine Ausführungsform eines integrierten elektronischen Bauteils mit Kontaktöffnungen, einem Klemmrand sowie einer einseitig mit einem Leistungsbauelement bestückten Leiterplatte;
- Fig. 2: eine alternative Ausführungsform zu Fig. 1 mit µ-Vias und einer doppelseitig mit Leistungsbauelementen bestückten Leiterplatte;
- Fig. 3: eine alternative Variante zu Fig. 1 mit einer zusätzlichen Kontaktöffnung im Bereich eines Klemmrandes;
- Fig. 4: eine alternative Ausführungsform zu Fig. 3 mit beidseitig der Leiterplatte angeordneten µ-Vias im Bereich des Klemmrandes;
- Fig. 5: eine Variante zu Fig. 3 mit beidseitig angeordneten Leistungsbauelementen; und
- Fig. 6: eine alternative Ausführungsform zu Fig. 1 mit beidseitig angeordneten Leistungsbauelementen.

### Beschreibung der Ausführungsbeispiele

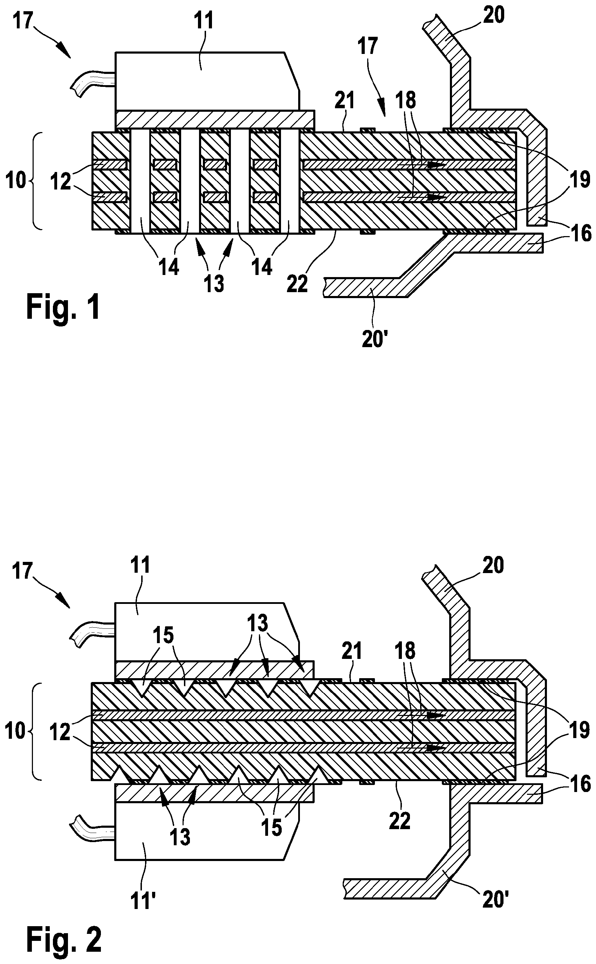

In den Fig. 1 bis 6 sind jeweils alternative Ausführungsformen eines erfindungsgemäßen integrierten elektronischen Bauteils 17 in einer Schnittdarstellung gezeigt. Gleiche Elemente sind in den Figuren jeweils mit gleichen Bezugszeichen versehen. Das integrierte elektronische Bauteil 10 umfasst jeweils eine Leiterplatte 10, insbesondere eine Multilayer-Leiterplatte 10, wenigstens ein auf der Leiterplatte 10 angeordnetes elektronisches Leistungsbauelement 11 sowie ein nicht gezeigtes Gehäuse, das die Leiterplatte 10 wenigstens teilweise umgibt. Die Leiterplatte 10 weist jeweils zwei strukturierbare Innenlagen 12 aus einem wärmeleitfähigem Material auf, wobei die Innenlagen 12 jeweils aus massivem Kupfer gebildet sind. Die Leistungsbauelemente 11 sind mit der Innenlage 12 jeweils über quer zur Leiterplatte 10 angeordnete Kontaktöffnungen 13 thermisch koppelbar, wobei eine Entwärmung der Leistungsbauelemente 11 stattfindet. Zur thermischen Ableitung von der Innenlage 12 ins Gehäuse ist jeweils ein Klemmrand 16 ausgebildet, wobei die Entwärmung über eine Querleitung 18 der beiden Innenlagen 12 zum Klemmrand 16 erfolgt. Der Klemmrand 16 umgibt zumindest teilweise eine Außenkante der Leiterplatte 10 und ist im Wesentlichen U-förmig geformt mit von einer Oberseite 21 und einer Unterseite 22 der Leiterplatte 10 abstehenden freien Schenkeln 20, 20'. Zur elektrischen Isolation der Innenlage 12 nach außen ist ein Material aus gefülltem organischem Substrat vorgesehen, insbesondere jeweils eine Prepreglage 19.

In Fig. 1 sind zur Entwärmung des Leistungsbauelements 11 Durchkontaktierungen vorgesehen, insbesondere parallel angeordnete Kontaktöffnungen 13 in Form von durchgängigen, quer zur Leiterplatte 10 angeordneten Bohrungen 14. Die Leiterplatte 10 ist in Fig. 1 einseitig auf der Oberseite 21 mit einem Leistungsbauelement 11 bestückt.

In Fig. 2 sind die Kontaktöffnungen 13 als Sacklöcher 15 (µ-Vias) ausgebildet. Über die Sacklöcher 15 wird die Wärme der Leistungsbauelemente 11 in die Innenlagen 12 und weiter über die Querleitungen 18 der Innenlagen 12 zum Klemmrand 16 abgeleitet, wo über die wärmeleitfähige organische Prepreglage 19 die Wärme nach außen abgeleitet wird. Dieser Aufbau ermöglicht eine vorteilhafte beidseitige Bestückung von Leistungsbauelementen 11, 11' auf der Oberseite 21 und der Unterseite 22 der Leiterplatte 10.

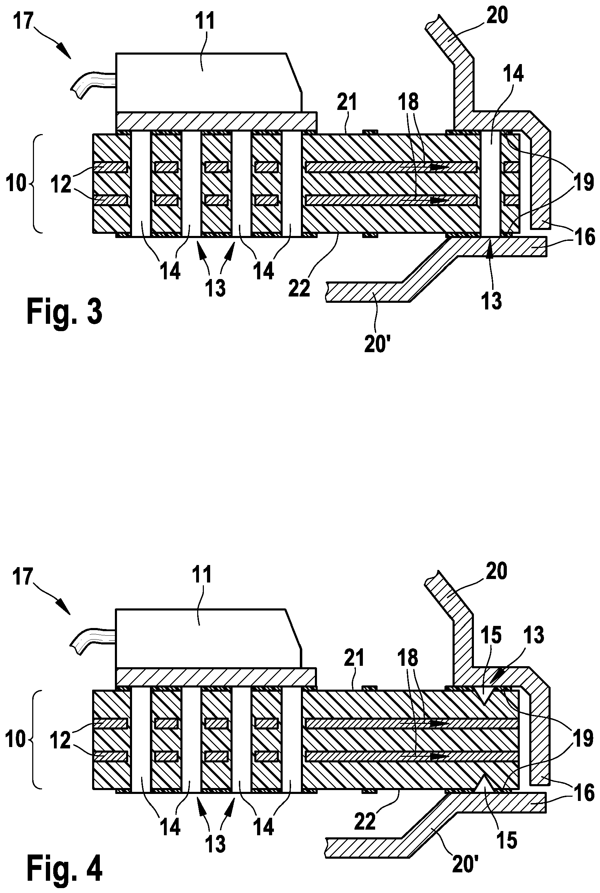

Fig. 3 zeigt eine Variante zu der Ausführungsform gemäß Fig. 1, die im Wesentlichen im Aufbau der Darstellung in Fig. 1 entspricht. Im Unterschied dazu weist die Leiterplatte 10 bei der in Fig. 3 dargestellten Ausführungsform im Bereich des Klemmrands 16 eine quer zur Leiterplatte 10 angeordnete Kontaktöffnung 13 in Form einer Bohrung 14 auf. Dieser Aufbau ist auf Leistungsbauelemente 11 beschränkt, die nicht potenzialfrei verbaut werden müssen.

In einer Variante zu Fig. 3 weist die Leiterplatte 10 in Fig. 4 im Bereich des Klemmrands 16 eine quer zur Leiterplatte 10 angeordnete Kontaktöffnung 13 in Form je eines Sacklochs 15 auf, das sowohl von der Oberseite 21 der Leiterplatte 10 sowie von der Unterseite 22 der Leiterplatte 10 nach innen gebohrt ist auf, und über welches die Entwärmung der Innenlagen 12 über den Klemmrand 16 zum Gehäuse erfolgt.

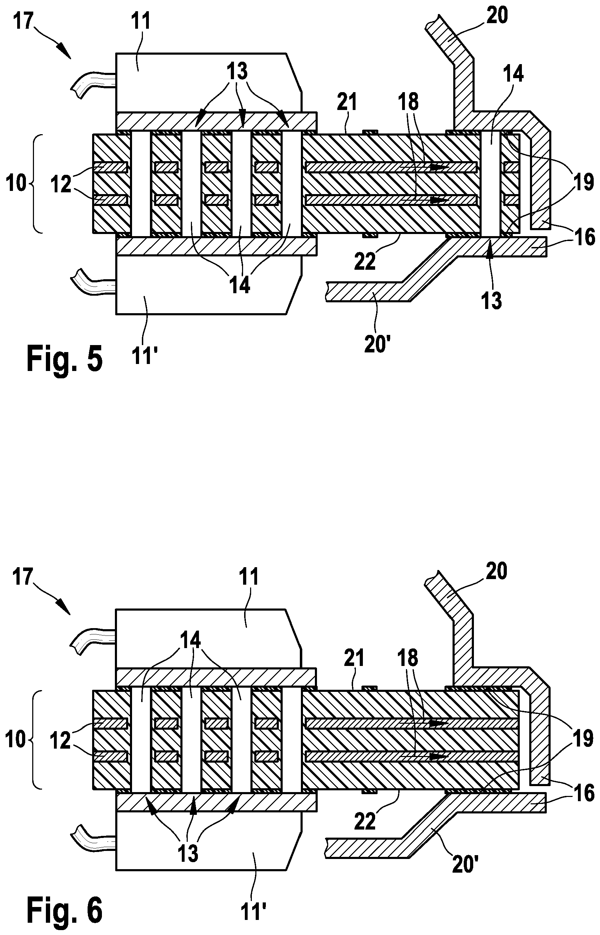

In Fig. 5 ist eine weitere alternative Ausführungsform zu Fig. 1 dargestellt. Zur Entwärmung des Leistungsbauelements 11 zu den Innenlagen 12 sind Durchkontaktierungen vorgesehen, insbesondere parallel angeordnete Kontaktöffnungen 13 in Form von durchgängigen, quer zur Leiterplatte 10 angeordneten Bohrungen 14. Darüber hinaus erfolgt eine Entwärmung der Innenlagen 12 zum Gehäuse über eine weitere als Bohrung 14 ausgebildete Durchkontaktierung entlang einer Querleitung 18 zum Klemmrand 16. Mit dieser vorgeschlagenen Lösung wird wiederum der thermischen Übergangswiderstand von der Leiterplatte 10 in das Gehäuse minimiert, so dass eine beidseitige Bestückung der Leiterplatte mit Leistungsbauelementen 11, 11' ermöglicht wird.

Eine andere alternative, die eine Möglichkeit zur Bestückung der Leiterplatte 10 mit Leistungsbauelementen 11, 11' auf einer Ober- und Unterseite 21,22 bereitstellt, ist in Fig. 6 gezeigt. Die in den Leistungsbauelementen 11, 11' erzeugte Wärme wird über Kontaktöffnungen 13 in Form von Bohrungen 14 zu den Innenlagen 12 abgeleitet. Die Wärmeableitung von den Innenlagen 12 zum Gehäuse findet über eine Querleitung 18 der Innenlagen 12 zu einem Klemmrand 16 statt. Mit Hilfe des Klemmrands 16 wird der thermische Übergangswiderstand so weit reduziert, dass eine beidseitige Bestückung der Leiterplatte 10 mit Leistungsbauelementen 11 ermöglicht wird.

## Patentansprüche

1. Integriertes elektronisches Bauteil mit einer Kühlvorrichtung zum Ableiten von Wärme mit wenigstens einer Leiterplatte (10), mit wenigstens einem auf der Leiterplatte (10) angeordneten elektronischen Leistungsbauelement (11), sowie einem Gehäuse, das zumindest teilweise eine Außenkante der Leiterplatte (10) über einen Klemmrand (16) umgibt,
**dadurch gekennzeichnet, dass**
die Leiterplatte wenigstens eine Innenlage (12) aus einem wärmeleitenden Material aufweist und die Wärmeableitung über eine Querleitung der Innenlage auf das Gehäuse erfolgt.

2. Bauteil nach Anspruch 1, **dadurch gekennzeichnet, dass** die wenigstens eine Innenlage (12) aus massivem Kupfer gebildet ist.

3. Bauteil nach Anspruch 1 oder 2, **dadurch gekennzeichnet, dass** die Innenlage (12) strukturiert ist.

4. Bauteil nach einem der vorhergehenden Ansprüche, **dadurch gekennzeichnet, dass** das Leistungsbauelement (11) mit der Innenlage (12) über wenigstens eine quer zur Leiterplatte (10) angeordnete Kontaktöffnung (13) thermisch koppelbar ist.

5. Bauteil nach Anspruch 4, **dadurch gekennzeichnet, dass** die Kontaktöffnung (13) als Bohrung ausgebildet ist.

6. Bauteil nach Anspruch 4 oder 5, **dadurch gekennzeichnet, dass** die Kontaktöffnung als Sackloch (15) ausgebildet ist.

7. Bauteil nach einem der Ansprüche 4 bis 6, **dadurch gekennzeichnet, dass** die Leiterplatte (10) im Bereich des Klemmrands (16) wenigstens eine quer zur Leiterplatte (10) angeordnete Kontaktöffnung (13) aufweist.

8. Bauteil nach einem der vorhergehenden Ansprüche, **dadurch gekennzeichnet, dass** zur elektrischen Isolation der Innenlage (12) nach außen ein Material aus gefülltem organischem Substrat vorgesehen ist.

## Claims

1. Integrated electronic component having a cooling device for dissipating heat, having at least one printed circuit board (10), having at least one electronic power module (11) arranged on the printed circuit board (10) and a housing which at least partly surrounds an outer edge of the printed circuit board (10) via a clamping edge (16),
**characterized in that**
the printed circuit board has at least one inner layer (12) made of thermally conductive material, and the dissipation of the heat is carried out via a transverse conductor of the inner layer to the housing.

2. Component according to Claim 1, **characterized in that** the at least one inner layer (12) is formed from solid copper.

3. Component according to Claim 1 or 2, **characterized in that** the inner layer (12) is structured.

4. Component according to one of the preceding claims, **characterized in that** the power module (11) can be coupled thermally to the inner layer (12) via at least one contact opening (13) arranged transversely relative to the printed circuit board (10).

5. Component according to Claim 4, **characterized in that** the contact opening (13) is formed as a drilled hole.

6. Component according to Claim 4 or 5, **characterized in that** the contact opening is formed as a blind hole (15).

7. Component according to one of Claims 4 to 6, **characterized in that** in the region of the clamping edge (16), the printed circuit board (10) has at least one contact opening (13) arranged transversely relative to the printed circuit board (10).

8. Component according to one of the preceding claims, **characterized in that** for the purpose of electrical insulation of the inner layer (12) with respect to the outside, a material made of filled organic substrate is provided.

## Revendications

1. Composant électronique intégré comprenant un dispositif de refroidissement destiné à dissiper la chaleur, au moins une carte de circuit imprimé (10), au moins un élément de puissance électronique (11) disposé sur la carte de circuit imprimé (10), et un boîtier entourant au moins partiellement un bord extérieur de la carte de circuit imprimé (10) par le biais d'un bord de serrage (16),
**caractérisé en ce que**
la carte de circuit imprimé comporte au moins une couche intérieure (12) en matériau thermiquement conducteur et la dissipation de chaleur s'effectue par le biais d'une ligne transversale de la couche intérieure sur le boîtier.

2. Composant selon la revendication 1, **caractérisé en ce que** l'au moins une couche intérieure (12) est constituée de cuivre massif.

3. Composant selon la revendication 1 ou 2, **caractérisé en ce que** la couche intérieure (12) est structurée.

4. Composant selon l'une des revendications précédentes, **caractérisé en ce que** l'élément de puissance (11) peut être couplé thermiquement à la couche intérieure (12) par le biais d'au moins une ouverture de contact (13) ménagée transversalement à la carte de circuit imprimé (10).

5. Composant selon la revendication 4, **caractérisé en ce que** l'ouverture de contact (13) est réalisée sous la forme d'un alésage.

6. Composant selon la revendication 4 ou 5, **caractérisé en ce que** l'ouverture de contact est réalisée sous la forme d'un trou borgne (15).

7. Composant selon l'une des revendications 4 à 6, **caractérisé en ce que** la carte de circuit imprimé (10) comporte, dans la région du bord de serrage (16), au moins une ouverture de contact (13) ménagée transversalement à la carte de circuit imprimé (10).

8. Composant selon l'une des revendications précédentes, **caractérisé en ce que**, pour isoler électriquement la couche intérieure (12) par rapport à l'extérieur, un matériau est prévu, lequel est constitué d'un substrat organique chargé.
